# EUROPEAN PATENT APPLICATION

(11) **EP 4 641 021 A1**
(43) Date of publication of application: **29.10.2025**
(21) Application number: 23907039.4
(22) Date of filing: 19.12.2023
(51) Int. Cl.: F04D 19/04

(54) **VACUUM PUMP**

(30) Priority: 19.12.2022 JP 2022202392
(71) Applicant: Edwards Japan Limited, Yachiyo-shi, Chiba 276-8523 (JP)
(72) Inventor: SATO Kentaro, Yachiyo-shi Chiba 276-8523 (JP); MIWATA Tooru, Yachiyo-shi Chiba 276-8523 (JP); OGAWA Yohei, Yachiyo-shi Chiba 276-8523 (JP); OHTACHI Yoshinobu, Yachiyo-shi Chiba 276-8523 (JP); MAEJIMA Yasushi, Yachiyo-shi Chiba 276-8523 (JP); TAKAADA Tsutomu, Yachiyo-shi Chiba 276-8523 (JP)
(74) Representative: Openshaw & Co.
(86) International application number: PCT/JP2023/045491
(87) International publication number: WO 2024/135679

(57) **Abstract**

Provided is a vacuum pump that is capable of stably controlling the temperature of gas without impairing the cooling effect of the gas.

A vacuum pump includes: a casing; a rotor shaft that is rotatably supported inside the casing; a plurality of stages of rotor blades that are fixed to the rotor shaft and capable of rotating together with the rotor shaft; a plurality of stages of stator blades that are fixed to the casing and arranged between the plurality of stages of rotor blades; and a plurality of stages of stator blade spacers that support the plurality of stages of stator blades. The vacuum pump includes a temperature controlling means that is provided in a specific spacer constituting one of the plurality of stages of stator blade spacers and controls a temperature of the specific spacer, and a temperature sensor that is provided at a position closer to the temperature controlling means than a gas flow path of a turbo pump portion constituted by the plurality of stages of rotor blades and the plurality of stages of stator blades.

## Description

The present invention relates to a vacuum pump.

For example, a turbomolecular pump described in Patent Literature 1 includes a temperature regulating unit provided between a casing and a base as a related art in this technical field. The temperature regulating unit is configured to include a temperature regulating spacer that constitutes a pump housing with the casing and the base, a cooling water tube provided in the temperature regulating spacer, a heater, and a temperature detecting portion. Further, according to Patent Literature **1,** the turbomolecular pump improves the temperature controllability of stator blades on the downstream side of a turbine pump portion.

Patent Literature 1: Japanese Patent Application Laid-open No. 2022-073913

However, the water cooling tube is provided at a position close to a gas flow path in the temperature regulating unit of Patent Literature 1. Therefore, there is a problem that the temperature of gas is easily influenced by the temperature of the water cooling tube and that the control of the temperature of the gas is not stabilized.

In view of the above problem, the present invention has an object of providing a vacuum pump that is capable of stably controlling the temperature of gas without impairing the cooling effect of the gas.

In order to achieve the above object, an aspect of the present invention provides a vacuum pump including: a casing; a rotor shaft that is rotatably supported inside the casing; a plurality of stages of rotor blades that are fixed to the rotor shaft and capable of rotating together with the rotor shaft; a plurality of stages of stator blades that are fixed to the casing and arranged between the plurality of stages of rotor blades; and a plurality of stages of stator blade spacers that support the plurality of stages of stator blades, wherein the vacuum pump includes a temperature controlling means that is provided in a specific spacer constituting one of the plurality of stages of stator blade spacers and controls a temperature of the specific spacer, and a temperature sensor that is provided at a position closer to the temperature controlling means than a gas flow path of a turbo pump portion constituted by the plurality of stages of rotor blades and the plurality of stages of stator blades.

In the above configuration, the casing includes an outer cylinder that is arranged on an outer peripheral side of the rotor shaft and a base portion that is arranged below the outer cylinder, and the specific spacer is made of a member having higher heat conductivity than the outer cylinder.

In the above configuration, the specific spacer is made of an aluminum material.

In the above configuration, the specific spacer is arranged between a stator blade of an uppermost stage and a stator blade of a lowermost stage among the plurality of stages of stator blades.

In the above configuration, the specific spacer covers an outer peripheral side of a stator blade spacer adjacent in an axial direction.

In the above configuration, the specific spacer includes a supporting portion that supports the stator blade spacer adjacent in the axial direction and an overhanging portion that overhangs from the supporting portion to an outside in a radial direction and covers the outer peripheral side of the stator blade spacer, and thickness of the overhanging portion is greater than thickness of the supporting portion.

In the above configuration, the temperature sensor is provided at a position between the gas flow path and the temperature controlling means in a radial direction.

In the above configuration, the vacuum pump further includes: a stator component that is arranged on a downstream side of the plurality of stages of rotor blades and the plurality of stages of stator blades and constitutes a part of a thread groove pump portion, and the stator component is heated by a heating means.

According to a vacuum pump of the present invention, it is possible to stably control the temperature of gas without impairing the cooling effect of the gas. Note that problems, configurations, effects other than the above are made obvious by the descriptions of the following embodiments.
FIG. 1 is a vertical cross-sectional view of a turbomolecular pump according to a first embodiment of the present invention;
FIG. 2 is a circuit diagram of an amplifier circuit of the turbomolecular pump shown in FIG. 1;
FIG. 3 is a time chart showing the control of an amplifier controlling circuit in a case in which a current command value is greater than a detected value;
FIG. 4 is a time chart showing the control of the amplifier controlling circuit in a case in which the current command value is smaller than the detected value;
FIG. 5 is an essential-portion enlarged view showing an A-portion of FIG. 1 in an enlarged fashion;
FIG. 6 is a vertical cross-sectional view showing the details of a water cooled spacer shown in FIG. 5;
FIG. 7 is a vertical cross-sectional view of a turbomolecular pump according to a second embodiment of the present invention;
FIG. 8 is an essential-portion enlarged view showing a B-portion of FIG. 7 in an enlarged fashion; and
FIG. 9 is a vertical cross-sectional view showing the details of a water cooled spacer shown in FIG. 8.

Hereinafter, embodiments of a vacuum pump according to the present invention will be described with reference to the drawings using a turbomolecular pump as an example.

### First Embodiment

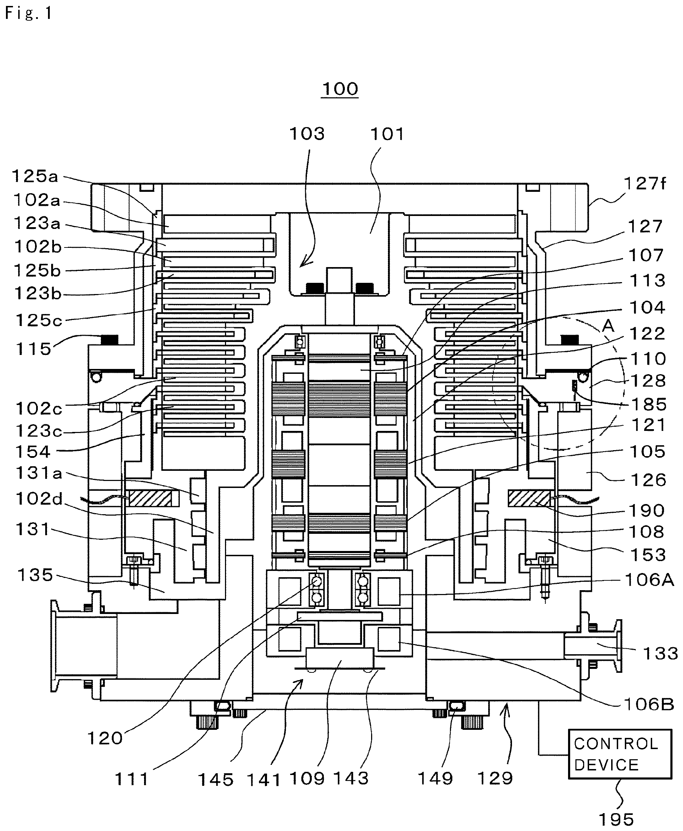

FIG. 1 shows a vertical cross-sectional view of a turbomolecular pump 100. In FIG. 1, the turbomolecular pump 100 has an inlet port 101 at the upper end of a cylindrical outer cylinder 127. Inside the outer cylinder 127, the turbomolecular pump 100 includes a rotating body 103 having a plurality of rotor blades 102 (102a, 102b, 102c, etc.) serving as turbine blades for sucking and exhausting gas at its peripheral portion radially and in multiple stages. At the center of the rotating body 103, a rotor shaft 113 is attached. The rotor shaft 113 is floated and positioncontrolled in the air by, for example, a five-axis control magnetic bearing. The rotating body 103 is generally made of metal such as aluminum, an aluminum alloy, and stainless steel.

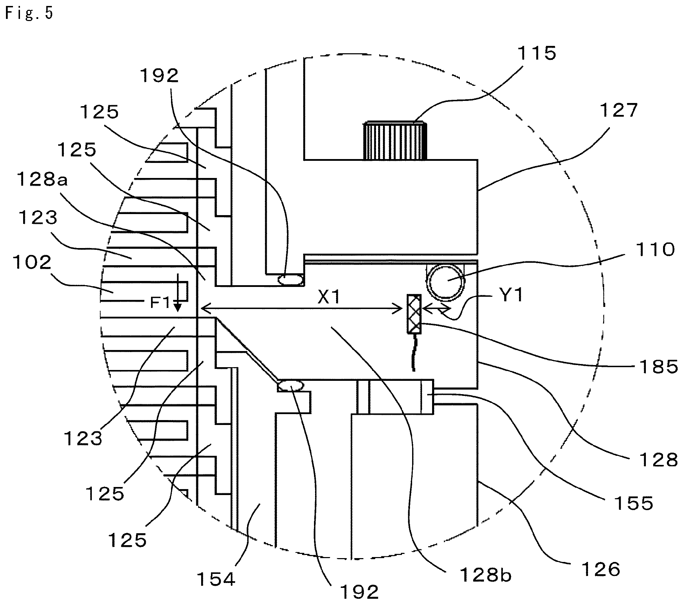

Further, as shown in FIG. 1, a water cooled spacer 128 and an outer wall 126 serving as outer peripheral components are arranged on the outer peripheral side of the rotating body 103. The water cooled spacer 128 is a ring-shaped member in which a ring-shaped cooling tube 110 (see FIG. 5) serving as a temperature controlling means and a temperature sensor 185 are included. By the supply of cooling water to the cooling tube 110, components around the water cooled spacer 128 are cooled. That is, heat generated by the rotation of the rotating body 103 is cooled by the water cooled spacer 128. The outer wall 126 is a cylindrical member surrounding the substantially lower half of the turbomolecular pump 100. The water cooled spacer 128 and the outer wall 126 are aligned in sequence coaxially with the outer cylinder 127 below the outer cylinder 127. The outer cylinder 127, the water cooled spacer 128, and the outer wall 126 are fastened and integrated by a plurality of bolts 115 and constitute the housing (casing) of the turbomolecular pump 100 that accommodates the rotating body 103 with a base portion 129.

Here, the water cooled spacer 128 also serves as a stator blade spacer 125 that will be described later. That is, the water cooled spacer 128 (specific spacer) constitutes one (one stage) of a plurality of stator blade spacers 125. Note that the water cooled spacer 128 is made of a member having higher heat conductivity than the outer cylinder 127 or the outer wall 126, for example, an aluminum material.

Four upper radial electromagnets 104 are arranged in pairs in X and Y axes. Four upper radial sensors 107 are provided so as to be close to the upper radial electromagnets 104 and correspond to the respective upper radial electromagnets 104. Inductance sensors, eddy-current sensors, or the like having a conductive coil are, for example, used as the upper radial sensors 107. The position of the rotor shaft 113 is detected on the basis of a change in the inductance of the conductive coil that changes in accordance with the position of the rotor shaft 113. The upper radial sensors 107 are configured to detect the radial displacement of the rotor shaft 113, that is, the radial displacement of the rotating body 103 fixed to the rotor shaft 113 and transmit the detected displacement to a control device 195.

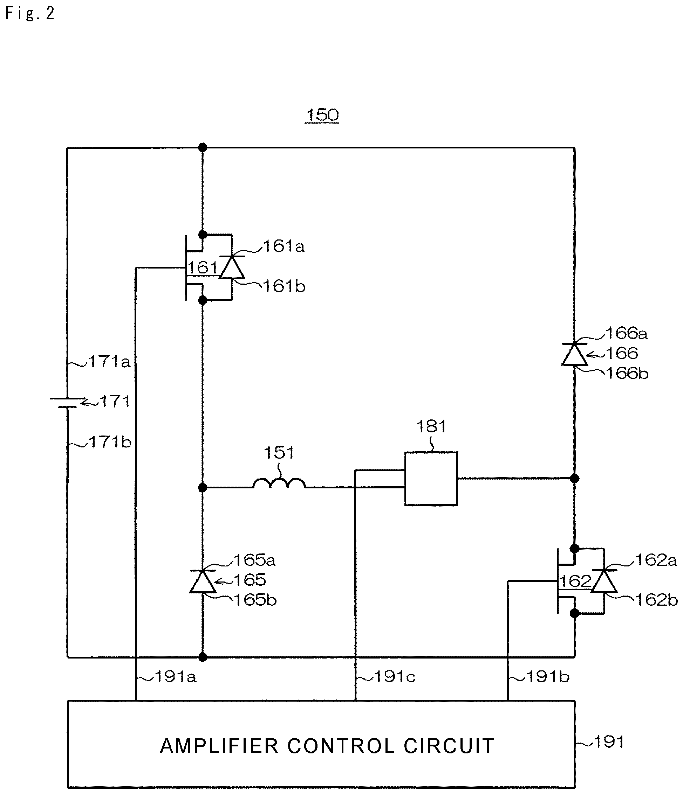

In the control device 195, for example, a compensating circuit having a PID adjusting function generates an excitation control command signal for the upper radial electromagnets 104 on the basis of a position signal detected by the upper radial sensors 107, and an amplifier circuit 150 (that will be described later) shown in FIG. 2 controls the excitation of the upper radial electromagnets 104 on the basis of the excitation control command signal. Thus, the upper radial position of the rotor shaft 113 is adjusted.

The rotor shaft 113 is made of a high permeability material (such as iron and stainless steel) or the like and sucked by the magnetic forces of the upper radial electromagnets 104. The adjustment is separately performed in each of an X-axis direction and a Y-axis direction. Further, lower radial electromagnets 105 and lower radial sensors 108 are arranged like the upper radial electromagnets 104 and the upper radial sensors 107 and adjust the lower radial position of the rotor shaft 113 like the upper radial position.

In addition, axial electromagnets 106A and 106B are arranged with a disc-shaped metal disc 111 at the lower portion of the rotor shaft 113 held therebetween in a vertical direction. The metal disc 111 is made of a high permeability material such as iron. An axial sensor 109 is provided to detect the axial displacement of the rotor shaft 113, and an axial position signal detected by the axial sensor 109 is configured to be transmitted to the control device 195.

Then, in the control device 195, for example, the compensating circuit having the PID adjusting function generates an excitation control command signal for each of the axial electromagnet 106A and the axial electromagnet 106B on the basis of the axial position signal detected by the axial sensor 109, and the amplifier circuit 150 controls the excitation of each of the axial electromagnet 106A and the axial electromagnet 106B on the basis of the excitation control command signal. Thus, the axial electromagnet 106A sucks the metal disc 111 upward by a magnetic force, and the axial electromagnet 106B sucks the metal disc 111 downward by a magnetic force, so that the axial position of the rotor shaft 113 is adjusted.

As described above, the control device 195 appropriately adjusts a magnetic force applied to the metal disc 111 by the axial electromagnets 106A and 106B and magnetically floats the rotor shaft 113 in an axial direction and retains the same in a non-contact manner in a space. Note that the amplifier circuit 150 that controls the excitation of the upper radial electromagnets 104, the lower radial electromagnets 105, and the axial electromagnets 106A and 106B will be described later.

Meanwhile, a motor 121 includes a plurality of magnetic poles circumferentially arranged so as to surround the rotor shaft 113. The respective magnetic poles are controlled by the control device 195 so as to rotate and drive the rotor shaft 113 via an electromagnetic force applied between the respective magnetic poles and the rotor shaft 113. Further, a rotating speed sensor such as a hall element, a resolver, and an encoder not shown is, for example, incorporated into the motor 121, and the rotating speed of the rotor shaft 113 is detected by the detection signal of the rotating speed sensor.

In addition, a phase sensor not shown is attached near, for example, the lower radial sensors 108 and detects the phase of the rotation of the rotor shaft 113. The control device 195 detects the positions of the magnetic poles using both the detection signals of the phase sensor and the rotating speed sensor.

A plurality of stator blades 123 (123a, 123b, 123c, etc.) are disposed with a slight gap with respect to the rotor blades 102 (102a, 102b, 102c, etc.). By a plurality of stages of the rotor blades 102 and a plurality of stages of stator blades 123, the turbo pump portion is constituted. Each of the rotor blades 102 (102a, 102b, 102c, etc.) is formed to be inclined by a prescribed angle from a plane perpendicular to the axial line of the rotor shaft 113 to transfer the molecules of exhaust gas downward by collision. The stator blades 123 (123a, 123b, 123c, etc.) are made of, for example, metal such as aluminum, iron, stainless steel, and copper or metal such as an alloy containing these metal as components.

Further, the stator blades 123 are also similarly formed to be inclined by a prescribed angle from the plane perpendicular to the axial line of the rotor shaft 113 and disposed alternately with the stages of the rotor blades 102 toward the inside of the outer cylinder 127. The outer peripheral ends of the stator blades 123 are supported in a state of being fitted and inserted between a plurality of stacked stator blade spacers 125 (125a, 125b, 125c, etc.).

The stator blade spacers 125 are ring-shaped members and made of, for example, metal such as aluminum, iron, stainless steel, and copper or metal such as an alloy containing these metal as components. On the periphery of the stator blade spacers 125, the outer cylinder 127 is fixed with a slight gap. The base portion 129 is disposed at the bottom of the outer cylinder 127 (more specifically, at the bottom of the outer wall 126). An outlet port 133 is formed above the base portion 129 and communicates with the outside. Exhaust gas transferred to the base portion 129 after entering the inlet port 101 from the side of a chamber (vacuum chamber) is supplied to the outlet port 133.

In addition, a threaded spacer 131 serving as a thread groove pump portion is disposed between the lower portion of the stator blade spacers 125 and the base portion 129 according to the use of the turbomolecular pump 100. The threaded spacer 131 is a cylindrical member made of metal such as aluminum, copper, stainless steel, iron, and an alloy containing these metal as components and has a plurality of spiral thread grooves 131a engraved on its inner peripheral surface. The spiral direction of the thread grooves 131a is a direction in which the molecules of exhaust gas are transferred to the outlet port 133 when the molecules move in the rotating direction of the rotating body 103. A cylindrical portion 102d suspends from a lowermost portion continuous with the rotor blades 102 (102a, 102b, 102c, etc.) of the rotating body 103. The outer peripheral surface of the cylindrical portion 102d has a cylindrical shape, overhangs toward the inner peripheral surface of the threaded spacer 131, and comes close to the inner peripheral surface of the threaded spacer 131 with a prescribed gap. The exhaust gas transferred to the thread grooves 131a by the rotor blades 102 and the stator blades 123 is supplied to the base portion 129, while being guided by the thread grooves 131a.

More specifically, the exhaust gas guided by the thread grooves 131a is supplied to an annular space 135 formed above the base portion 129 and exhausted to the outside via the outlet port 133 while orbiting around the annular space 135. The annular space 135 is an annular space partitioned by a cylindrical portion 102d of the rotating body 103, the threaded spacer 131, a heater spacer 153, and the base portion 129.

Here, the heater spacer 153 serving as a stator component is a member formed into a cylindrical shape and configured integrally with the threaded spacer 131 in the present embodiment. That is, the heater spacer 153 constitutes a part of the threaded spacer 131. Of course, the heater spacer 153 may be configured separately from the threaded spacer 131. The heater spacer 153 is made of, for example, metal such as aluminum and stainless steel. A heater 190 serving as a heating means is inserted into the heater spacer 153. As the heater 190 generates heat, the threaded spacer 131 is heated via the heater spacer 153. Further, the exhaust gas flowing through the annular space 135 is also heated by the heater 190. Thus, the generation of a deposit due to a reduction in the temperature of the exhaust gas is suppressed. Further, an inner spacer 154 is a cylindrical member made of, for example, metal such as stainless steel and insulates the water cooled spacer 128 from the stator blade spacers 125 on the lower side of the water cooled spacer 128.

The base portion 129 is a disc-shaped member constituting the base portion of the turbomolecular pump 100 and generally made of metal such as iron, aluminum, and stainless steel. Since the base portion 129 serves also as a heat conducting path besides physically retaining the turbomolecular pump 100, metal such as iron, aluminum and copper having stiffness and high heat conductivity is desirably used as such.

According to the above configuration, exhaust gas is sucked from the chamber via the inlet port 101 by the operation of the rotor blades 102 and the stator blades 123 when the rotor blades 102 are rotationally driven by the motor 121 together with the rotor shaft 113. The rotor blades 102 generally have a rotating speed of 20,000 rpm to 90,000 rpm, and the peripheral speed at the tip ends of the rotor blades 102 reaches 200 m/s to 400 m/s. The exhaust gas sucked via the inlet port 101 is transferred to the base portion 129 after passing through between the rotor blades 102 and the stator blades 123. At this time, the temperature of the rotor blades 102 increases due to friction heat generated when the exhaust gas contacts the rotor blades 102, the conduction of heat generated by the motor 121, or the like. However, the heat is transferred to the side of the stator blades 123 through radiation or conduction by the gas molecules or the like of the exhaust gas.

The stator blade spacers 125 are bonded to each other at an outer peripheral portion and transfer heat received by the stator blades 123 from the rotor blades 102, friction heat generated when exhaust gas contacts the stator blades 123, or the like to the outside.

Note that the above description assumes that the threaded spacer 131 is disposed on the periphery of the cylindrical portion 102d of the rotating body 103, and that the thread grooves 131a are engraved on the inner peripheral surface of the threaded spacer 131. Contrary to this, there is also a case that thread grooves are engraved on the outer peripheral surface of the cylindrical portion 102d, and that a spacer having a cylindrical inner peripheral surface is arranged around the thread grooves.

Further, depending on the use of the turbomolecular pump 100, there is also a case that the surrounding area of an electrical portion including the upper radial electromagnets 104, the upper radial sensors 107, the motor 121, the lower radial electromagnets 105, the lower radial sensors 108, the axial electromagnets 106A and 106B, the axial sensor 109, or the like is covered with a stator column 122, and that the pressure inside the stator column 122 is retained at a prescribed pressure by a purge gas in order to prevent gas sucked via the inlet port 101 from entering the electrical portion.

In this case, piping not shown is disposed in the base portion 129, and a purge gas is introduced via the piping. The introduced purge gas is delivered to the outlet port 133 via a gap between a protecting bearing 120 and the rotor shaft 113, a gap between the rotor and the stator of the motor 121, and a gap between the stator column 122 and a cylindrical portion on the inner peripheral side of the rotor blades 102. Note that the stator column 122 is erected at the central position of the base portion 129 as shown in FIG. **1****.** Further, a water cooled tube 149 serving as a cooling means is provided in the base portion 129 in the present embodiment. By the supply of cooling water to the water cooled tube 149, the base portion 129 and the stator column 122 are kept at a suitable temperature.

Here, the turbomolecular pump 100 requires control based on the specification of a model and separately-adjusted unique parameters (for example, various characteristics corresponding to the model). In order to store the control parameters, the turbomolecular pump 100 includes an electronic circuit portion 141. The electronic circuit portion 141 includes electronic components such as a semiconductor memory like an EEP-ROM and a semiconductor element for accessing the semiconductor memory, a substrate 143 for mounting the electronic components, or the like. The electronic circuit portion 141 is accommodated at, for example, the lower portion of a rotating speed sensor not shown near the center of the base portion 129 constituting the lower portion of the turbomolecular pump 100, and is closed by an air-tight bottom lid 145.

Meanwhile, in a semiconductor manufacturing process, some process gases introduced into a chamber have the property of becoming solid when their pressure becomes higher than a prescribed value or when their temperature becomes lower than a prescribed value. Inside the turbomolecular pump 100, the pressure of exhaust gas is the lowest at the inlet port 101 and the highest at the outlet port 133. When the pressure of a process gas becomes higher than a prescribed value or when the temperature of the process gas becomes lower than a prescribed value during the transfer of the process gas from the inlet port 101 to the outlet port 133, the process gas becomes solid and adheres to and accumulates inside the turbomolecular pump 100.

For example, when SiCl4 is used as a process gas in an Al etching device, it appears from a vapor pressure curve that a solid product (for example, AlCl3) separates out and adheres to and accumulates inside the turbomolecular pump 100 in a low vacuum condition (from 760 Torr to 10⁻² Torr) and at a low temperature (about 20°C). Therefore, when the precipitate of a process gas accumulates inside the turbomolecular pump 100, the precipitate narrows down a pump flow path, which causes a reason for a reduction in the performance of the turbomolecular pump 100. Further, the product described above is liable to solidify at and adhere to a high-pressure portion near the outlet port 133 or the threaded spacer 131.

Therefore, in order to solve the above problem, a heater not shown or an annular water cooled tube 149 is wound on the periphery of the base portion 129 or the like, and a temperature sensor (for example, a thermistor) not shown is embedded in, for example, the base portion 129. Then, heating is performed by the heater or cooling control is performed by the water cooled tube 149 (hereinafter called TMS (Temperature Management System)) so that the temperature of the base portion 129 is retained at a constant high temperature (setting temperature) on the basis of a signal from the temperature sensor.

Next, in regard to the turbomolecular pump 100 thus configured, the amplifier circuit 150 that controls the excitation of the upper radial electromagnets 104, the lower radial electromagnets 105, and the axial electromagnets 106A and 106B will be described. FIG. 2 shows a circuit diagram of the amplifier circuit 150.

In FIG. 2, an electromagnet coil 151 constituting the upper radial electromagnets 104 or the like has one end thereof connected to a positive electrode 171a of a power supply 171 via a transistor 161 and the other end thereof connected to a negative electrode 171b of the power supply 171 via a current detecting circuit 181 and a transistor 162. The transistors 161 and 162 are so-called power MOSFETs and have a structure in which a diode is connected between a source and a drain.

On this occasion, a cathode terminal 161a of the diode of the transistor 161 is connected to the positive electrode 171a, and an anode terminal 161b thereof is connected to one end of the electromagnet coil 151. Further, a cathode terminal 162a of the diode of the transistor 162 is connected to the current detecting circuit 181, and an anode terminal 162b thereof is connected to the negative electrode 171b.

On the other hand, a cathode terminal 165a of a diode 165 for current regeneration is connected to one end of the electromagnet coil 151, and an anode terminal 165b thereof is connected to the negative electrode 171b. Further, a cathode terminal 166a of a diode 166 for current regeneration is similarly connected to the positive electrode 171a, and an anode terminal 166b thereof is connected to the other end of the electromagnet coil 151 via the current detecting circuit 181. The current detecting circuit 181 includes, for example, a hall sensor type current sensor or an electric resistance element.

The amplifier circuit 150 thus configured corresponds to one electromagnet. Therefore, in a case in which the magnetic bearing performs five-axis control and the total number of the electromagnets 104, 105, 106A, and 106B is ten, the same amplifier circuit 150 is constituted for each of the electromagnets, and the ten amplifier circuits 150 are connected in parallel to the power supply 171.

In addition, an amplifier control circuit 191 includes, for example, a digital signal processor portion (hereinafter called a DSP portion) not shown of the control device 195. The amplifier control circuit 191 switches the ON/OFF of the transistors 161 and 162.

The amplifier control circuit 191 compares a current value (a signal reflecting the current value is called a current detecting signal 191c) detected by the current detecting circuit 181 with a prescribed current command value. Then, on the basis of a result of the comparison, the amplifier control circuit 191 determines the size (pulse width time Tp1 or Tp2) of a pulse width to be generated in a control cycle Ts showing one cycle in PWM control. Consequently, the amplifier control circuit 191 outputs gate driving signals 191a and 191b having the pulse width to the gate terminals of the transistors 161 and 162.

Note that when passing through a resonance point during the accelerating operation of the rotation of the rotating body 103 or when disturbance occurs during an operation at a constant speed, the position of the rotating body 103 is required to be controlled at a high speed and with a great force. Therefore, a high voltage of, for example, about 50 V is used as the power supply 171 so that a rapid increase (or decrease) in a current flowing through the electromagnet coil 151 is enabled. Further, a capacitor is generally connected between the positive electrode 171a and the negative electrode 171b of the power supply 171 to stabilize the power supply 171 (not shown).

In the configuration, a current (hereinafter called an electromagnet current iL) flowing through the electromagnet coil 151 increases when both the transistors 161 and 162 are turned ON, and the electromagnet current iL decreases when both the transistors 161 and 162 are turned OFF.

Further, a so-called flywheel current is retained when one of the transistors 161 and 162 is turned ON and the other thereof is turned OFF. Then, the feeding of the flywheel current to the amplifier circuit 150 as described above leads to a decrease in hysteresis loss in the amplifier circuit 150, which makes it possible to reduce the power consumption of the whole circuit. Further, the control of the transistors 161 and 162 as described above enables a reduction in high-frequency noise such as a higher harmonic wave caused in the turbomolecular pump 100. In addition, the measurement of the flywheel current with the current detecting circuit 181 enables the detection of the electromagnet current iL flowing through the electromagnet coil 151.

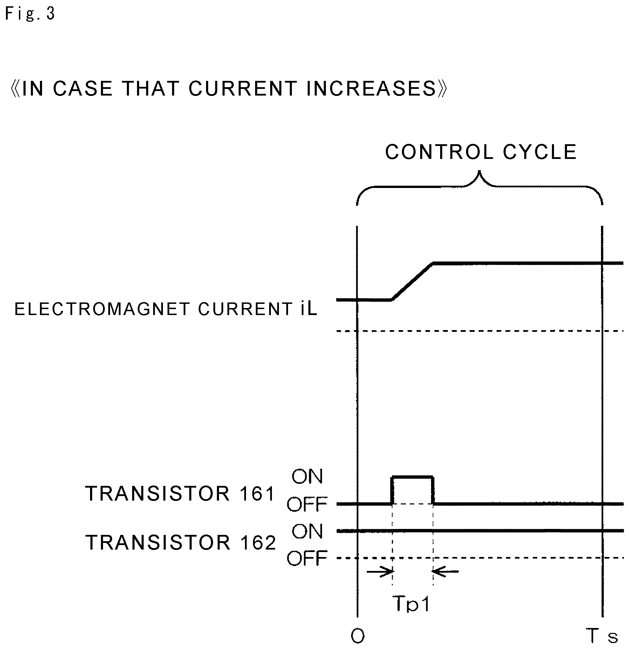

That is, when a detected current value is smaller than a current command value, the amplifier circuit 150 turns ON both the transistors 161 and 162 for a period corresponding to the pulse width time Tp1 only once in the control cycle Ts (for example, 100 µs) as shown in FIG. **3****.** Therefore, in the period, the electromagnet current iL increases toward a value iLmax (not shown) of the current capable of flowing through the transistors 161 and 162 from the positive electrode 171a to the negative electrode 171b.

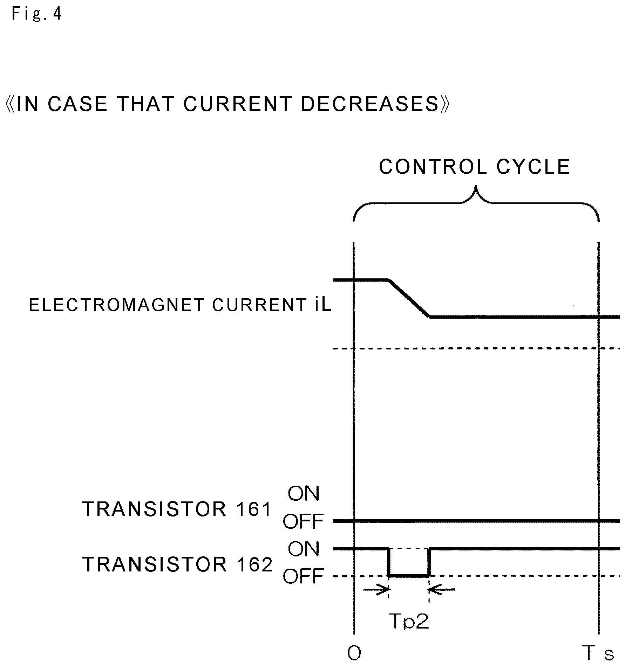

On the other hand, when the detected current value is greater than the current command value, the amplifier circuit 150 turns OFF both the transistors 161 and 162 for a period corresponding to the pulse width time Tp2 only once in the control cycle Ts as shown in FIG. 4. Therefore, in the period, the electromagnet current iL decreases toward a value iLmin (not shown) of the current capable of being regenerated through the diodes 165 and 166 from the negative electrode 171b to the positive electrode 171a.

Then, in both cases, the amplifier circuit 150 turns ON one of the transistors 161 and 162 after the elapse of the pulse width time Tp1 or Tp2. Therefore, the flywheel current is retained in the amplifier circuit 150 in the period.

Next, the characteristic portion of the turbomolecular pump 100 according to the present embodiment will be described in detail. FIG. 5 is an essential-portion enlarged view showing an A-portion of FIG. 1 in an enlarged fashion. As shown in FIG. 5, the water cooled spacer 128 is arranged at the position between the stator blade 123 of the uppermost stage and the stator blade 123 of the lowermost stage among the plurality of stages of stator blades 123. The water cooled spacer 128 serves as a stator blade spacer 125 that positions the stator blades 123 in the axial direction and serves also to cool the stator blades 123 to reduce the temperature of the rotor blades 102 by radiation heat. As a result, not only gas contacting the water cooled spacer 128 but also gas contacting the stator blades 123 is cooled.

The water cooled spacer 128 includes the cooling tube 110 and the temperature sensor 185 as described above. The cooling tube 110 is provided at the outer peripheral portion of the water cooled spacer 128. The temperature sensor 185 is provided on the inner side in the radial direction of the cooling tube 110 and in the vicinity of the cooling tube 110. More specifically, the temperature sensor 185 is provided at the position that is separated from the inner peripheral portion of the water cooled spacer 128 (the portion of the water cooled spacer 128 that contacts a gas flow path F1) by a distance X1 and that is away inward in the radial direction from the cooling tube 110 by a distance Y1. Further, the distance X1 is significantly longer than the distance Y1. That is, the temperature sensor 185 is provided at the position that is separated from the gas flow path F1 and that is close to the cooling tube 110.

Note that the ratio of the distance X1 to the distance Y1 may be arbitrarily set on the basis of specifications such as the material of the water cooled spacer 128, the flow rate and the temperature of cooling water flowing through the cooling tube 110, and the flow rate and the temperature of gas flowing through the gas flow path F1 but may be set within, for example, the range of 2:1 to 10:1 or so.

The water cooled spacer 128 is arranged between the outer cylinder 127 and the outer wall 126 and fixed by the bolts 115. Further, a heat insulating ring 155 is interposed between the water cooled spacer 128 and the outer wall 126. By the heat insulating ring 155, the water cooled spacer 128 and the outer wall 126 are thermally insulated from each other. Further, an O-ring 192 is attached between the outer cylinder 127 and the water cooled spacer 128 and between the inner spacer 154 and the water cooled spacer 128 to maintain airtightness.

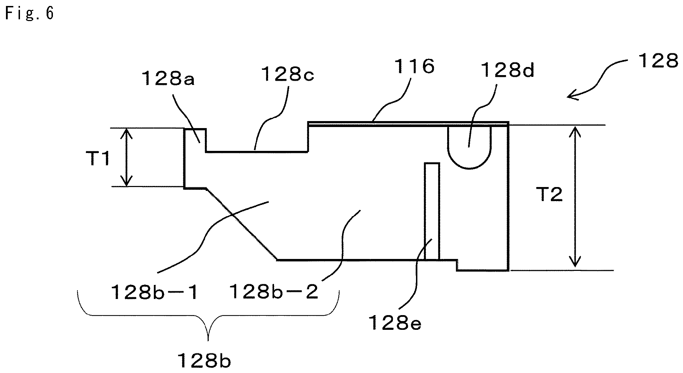

Next, the shape of the water cooled spacer 128 will be described in detail. FIG. 6 is a vertical cross-sectional view showing the details of the water cooled spacer 128 shown in FIG. 5. As shown in FIG. 6, the water cooled spacer 128 includes a supporting portion 128a and an overhanging portion 128b. The supporting portion 128a supports the stator blade spacers 125 adjacent in the axial direction and positions the adjacent stator blades 123 in the axial direction (vertical direction). The overhanging portion 128b is provided overhanging from the supporting portion 128a to the outside in the radial direction and has a tapered portion 128b-1 and a barrel portion 128b-2.

The tapered portion 128b-1 is inclined so as to follow the shape of the upper end side of the inner spacer 154. Further, a step portion 128c notched in a ring shape is formed on the upper surface of the tapered portion 128b-1.

A ring-shaped groove portion 128d is provided at the end on the outer peripheral side of the upper surface of the barrel portion 128b-2, and the cooling tube 110 is arranged in the groove portion 128d. Further, a slender attachment hole 128e is provided in the axial direction at one spot on the lower surface of the barrel portion 128b-2. The attachment hole 128e is used to insert the temperature sensor 185. Note that symbol 116 shows a cover for covering the cooling tube 110.

As described above, the water cooled spacer 128 formed into a ring shape as a whole is configured so that the barrel portion 128b-2 extends downward and outward in the radial direction via the tapered portion 128b-1 from the supporting portion 128a. Further, thickness T2 of the overhanging portion 128b is greater than thickness (the length in the axial direction) T1 of the supporting portion 128a. More specifically, the thickness T2 is about 2.5 times as large as the thickness T1. Accordingly, the water cooled spacer 128 realizes high stiffness with the thick overhanging portion 128b. By the configuration, the tapered portion 128b-1 covers the outside of the inner spacer 154 when the water cooled spacer 128 is arranged at the position shown in FIG. 5.

Next, the effects of the present embodiment thus configured will be described.

The turbomolecular pump 100 according to the present embodiment includes the water cooled spacer 128. The water cooled spacer 128 has the cooling tube 110 and the temperature sensor 185. Further, the temperature sensor 185 is provided in the vicinity of the cooling tube 110.

The cooling water flowing through the cooling tube 110 is controlled by turning on/off a valve not shown on the basis of temperature data from the temperature sensor 185. When the temperature inside the turbomolecular pump 100 rises, the valve of the cooling tube 110 is turned on to control the temperature of the water cooled spacer 128, particularly, the temperature of the inner peripheral portion of the water cooled spacer 128 (the portion of the water cooled spacer 128 that contacts the gas flow path F1).

In the temperature controlling system as described above, an overshoot occurs with respect to a target temperature. However, the temperature of the cooling tube 110 is detectable with high accuracy since the temperature sensor 185 is provided in the vicinity of the cooling tube 110 as described above. As a result, the control device 195 is enabled to control the temperature of the inner peripheral portion of the water cooled spacer 128 that contacts the gas inside the turbomolecular pump 100 with high accuracy on the basis of temperature data from the temperature sensor 185. Further, since the distance X1 is longer than the distance Y1, an overshoot hardly occurs in the temperature control of the inner peripheral portion of the water cooled spacer 128 with respect to a change in the temperature of the cooling tube 110. That is, a change in the temperature of the water cooled spacer 128 with respect to a change in the temperature of the cooling tube 110 is made dull, whereby the temperature of the inner peripheral portion of the water cooled spacer 128 is easily kept at a fixed temperature. As described above, it is possible to stably control the temperature of the inner peripheral portion of the water cooled spacer 128 that contacts the gas flow path F1 without impairing the cooling effect of the cooling tube 110 according to the present embodiment. Further, since the temperature of the inner peripheral portion of the water cooled spacer 128 is stabilized, the cooling state of the stator blades 123 is also stabilized. As a result, the temperature of the rotor blades 102 is also stabilized.

Further, the water cooled spacer 128 is made of a member having higher conductivity than the outer cylinder 127 and the outer wall 126, specifically, an aluminum material. The purpose of using a member having high heat conductivity is to make the temperature of the water cooled spacer 128 easily change with a small cooling amount. However, by setting the distance X1 to be longer than the distance X2, it is possible to reduce an overshoot and reach a target temperature as quickly as possible at the inner peripheral portion of the water cooled spacer 128 that contacts the gas flow path F1.

That is, a change in the temperature of the cooling tube 110 is detected with high accuracy by the temperature sensor 185 arranged in the vicinity of the cooling tube 110 according to the present embodiment, whereby the temperature of the water cooled spacer 128 is easily controlled at a target temperature, while the change in the temperature of the cooling tube 110 is controlled to be suppressed. Further, the cooling tube 110 and the gas flow path F1 are separated from each other by the distance X1, whereby it is possible to prevent a rapid change in the temperature of the cooling tube 110 from being transmitted to the inner peripheral surface of the water cooled spacer 128 that contacts the gas flow path F1 even when the water cooled spacer 128 is made of a member having high heat conductivity. In addition, the water cooled spacer 128 is made of a member having high heat conductivity such as an aluminum material, whereby it is possible to cool the temperature of the inner peripheral surface of the water cooled spacer 128 that contacts the gas flow path F1 to a desired temperature even if the cooling tube 110 is separated from the gas flow path F1.

Further, since the temperature sensor 185 is provided on the inner side in the radial direction of the cooling tube 110, it is possible to detect the temperature of the cooling tube 110 with high accuracy without being influenced by the temperatures of components around the water cooled spacer 128.

Note that the temperature of the cooling water flowing through the cooling tube 110 is arbitrary. Since the water cooled spacer 128 is used to cool the stator blades 123 to cool the rotor blades 102 by radiation heat as described above, the temperature of the cooling water may only be a temperature suitable for cooling the rotor blades 102. Therefore, the temperature of the cooling water is possibly less than 100 degrees or 100 degrees or more depending on the temperature inside the turbomolecular pump 100.

Further, the water cooled spacer 128 includes the supporting portion 128a and the overhanging portion 128b, and the overhanging portion 128b is structured to be thicker than the supporting portion 128a. Therefore, it is possible to prevent the deformation of the water cooled spacer 128, particularly, the bending deformation of the water cooled spacer 128 in the axial direction. Further, since the overhanging portion 128b is configured to cover the outer peripheral side of the lower stator blade spacer 125 so as to follow the upper shape (tapered shape) of the inner spacer 154, it is possible to improve, using a dead space formed above the inner spacer 154, the stiffness of the water cooled spacer 128 without increasing its dimension in the axial direction. If the overhanging portion 128b is configured to extend upward from the supporting portion 128a in order to improve the stiffness of the water cooled spacer 128, the turbomolecular pump 100 is lengthened as a whole in the axial direction. However, the turbomolecular pump 100 is not lengthened according to the shape of the embodiment.

Further, since the heater 190 is configured to be provided in the heater spacer 153 that is arranged on the downstream side of the plurality of rotor blades 102 and the plurality of stator blades 123 and that is a stator component constituting a part of the thread groove pump portion, it is possible to control the temperature of exhaust gas with higher accuracy.

### Second Embodiment

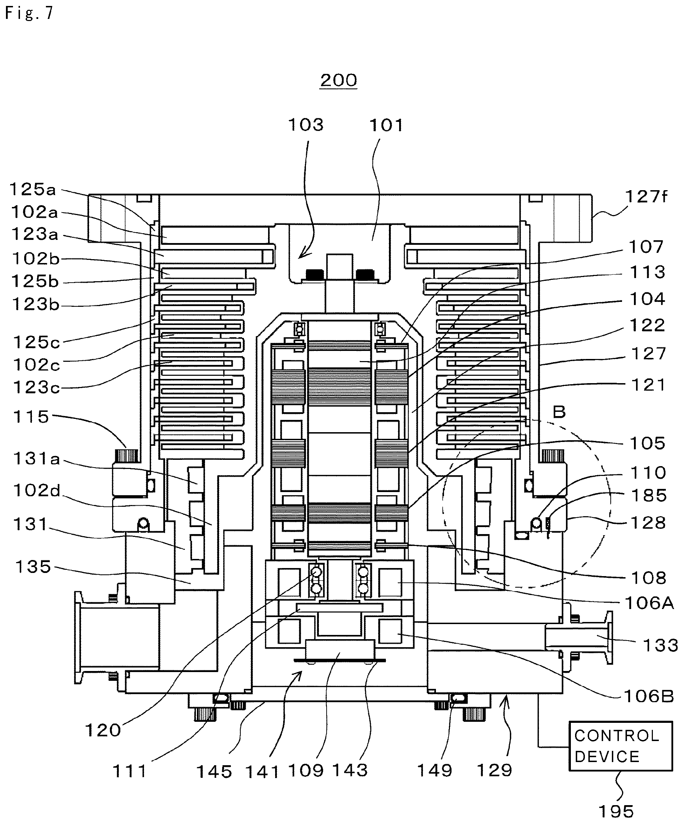

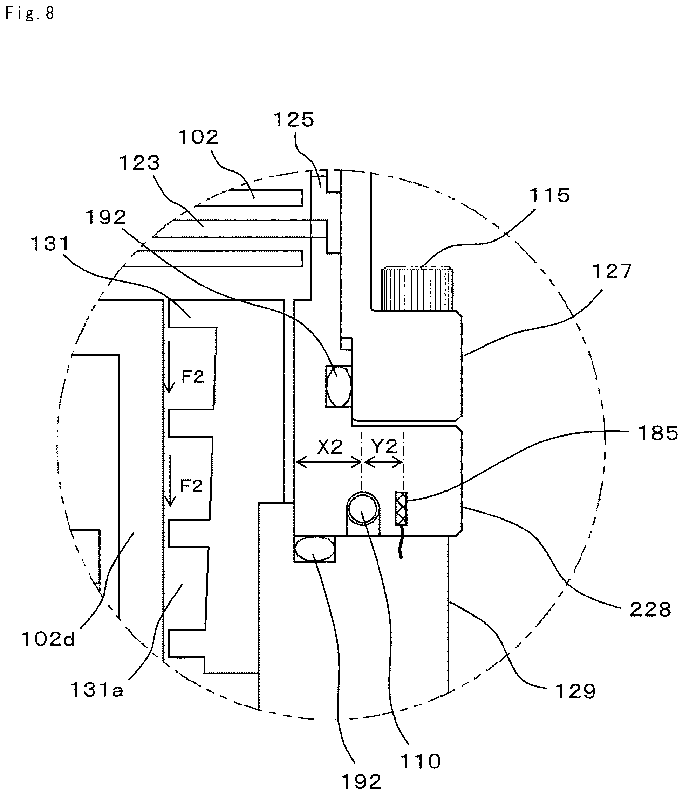

Next, a turbomolecular pump according to a second embodiment of the present invention will be described. FIG. 7 is a vertical cross-sectional view of a turbomolecular pump 200 according to the second embodiment of the present invention, and FIG. 8 is an essential-portion enlarged view showing a B-portion of FIG. 7 in an enlarged fashion. Note that the same configurations as those of the first embodiment will be denoted by the same signs and their descriptions will be omitted below.

As shown in these figures, the configuration of the water cooled spacer of the second embodiment is different from that of the water cooled spacer of the first embodiment. Specifically, in the first embodiment, the water cooled spacer 128 is arranged between the stator blade 123 of the uppermost stage and the stator blade 123 of the lowermost stage among the plurality of stages of stator blades 123. However, in the second embodiment, a water cooled spacer 228 is arranged at a stator blade 123 of a lowermost stage among a plurality of stages of stator blades 123. Therefore, the shapes of the water cooled spacers are different from each other between the first embodiment and the second embodiment.

The water cooled spacer 228 is made of an aluminum material like the first embodiment and includes a cooling tube 110 and a temperature sensor 185. Compared with the first embodiment, the cooling tube 110 is provided on the inner side in the radial direction of the outer peripheral portion of the water cooled spacer 228. Specifically, the cooling tube 110 is provided at the position that is separated from the inner peripheral portion (the side close to a gas flow path F2) of the water cooled spacer 228 by a distance X2. Further, the temperature sensor 185 is provided on the outer side in the radial direction of the cooling tube 110 and in the vicinity of the cooling tube 110. More specifically, the temperature sensor 185 is provided at the position that is away outward in the radial direction from the cooling tube 110 by a distance Y2. Further, the distance X2 is slightly longer than the distance Y2.

Note that the ratio of the distance X2 to the distance Y2 may be arbitrarily set on the basis of specifications such as the material of the water cooled spacer 228, the flow rate and the temperature of cooling water flowing through the cooling tube 110, and the flow rate and the temperature of gas flowing through the gas flow path F2 but may be set within, for example, the range of 1.5:1 to 3:1 or so.

The water cooled spacer 228 is arranged between an outer cylinder 127 and a base portion 129 and fixed by bolts 115. Further, an O-ring 192 is attached between the outer cylinder 127 and the water cooled spacer 228 and between the base portion 129 and the water cooled spacer 228 to maintain airtightness.

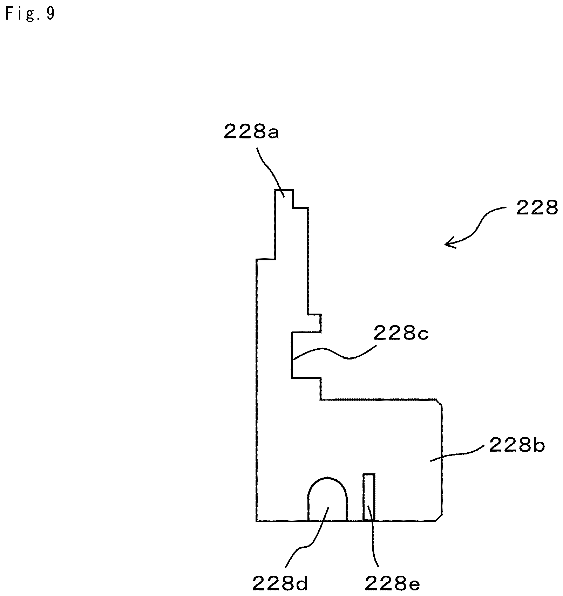

Next, the shape of the water cooled spacer 228 will be described in detail. FIG. 9 is a vertical cross-sectional view showing the details of the water cooled spacer 228 shown in FIG. 8. As shown in FIG. 9, the water cooled spacer 228 includes a supporting portion 228a and an overhanging portion 228b. The supporting portion 228a supports a stator blade spacer 125 adjacent in an axial direction and positions the adjacent stator blade 123 in the axial direction (vertical direction). The overhanging portion 128b is provided overhanging from the supporting portion 128a to the outside in the radial direction. Further, the cross section of the water cooled spacer 228 is formed into a substantially L-shape by the supporting portion 228a and the overhanging portion 228b.

A step portion 228c for attaching the O-ring 192 is formed on the supporting portion 228a. Further, a ring-shaped groove portion 228d and an attachment hole 228e are formed on the lower surface of the overhanging portion 228b. The cooling tube 110 is attached to the groove portion 228d, and the temperature sensor 185 is attached to the attachment hole 228e.

The second embodiment produces the same functions and effects as those of the first embodiment. Further, in the second embodiment, the water cooled spacer 228 is configured to be arranged at the stator blade 123 of the lowermost stage among the plurality of stages of stator blades 123. Therefore, it is possible to directly fix the water cooled spacer 228 to the base portion 129. Accordingly, an outer wall 126 as in the first embodiment becomes unnecessary, which makes it possible to simplify the structure of the turbomolecular pump 200.

Note that the present invention is not limited to the above embodiments and variously modifiable without departing from its gist. All the technical matters included in technical ideas described in claims become the subjects of the present invention. The embodiments described above show suitable examples. However, those skilled in the art could realize various substituting examples, correction examples, modified examples, combination examples, or improvement examples from the contents disclosed in the present specification, and these examples are included in the technical scope described in the attached claims.

100, 200 Turbomolecular pump (Vacuum pump)
102 (102a, 102b, 102c) Rotor blade
102d Cylindrical portion
103 Rotating body
113 Rotor shaft
116 Cover
122 Stator column
123 (123a, 123b, 123c) Stator blade
125 (125a, 125b, 125c) Stator blade spacer
126 Outer wall (Casing)
127 Outer cylinder (Casing)
128, 228 Water cooled spacer (Specific spacer)
128a, 228a Supporting portion
128b, 228b Overhanging portion
128b-1 Tapered portion
128b-2 Barrel portion
128c, 228c Step portion
128d, 228d Ring-shaped groove
128e, 228e Attachment hole
129 Base portion
131 Threaded spacer (Thread groove pump portion)
133 Outlet port
153 Heater spacer (Stator component)
154 Inner spacer
155 Heat insulating ring
185 Temperature sensor
190 Heater (Heating means)
192 O-ring
195 Control device

## Claims

1. A vacuum pump comprising:
a casing;
a rotor shaft that is rotatably supported inside the casing;
a plurality of stages of rotor blades that are fixed to the rotor shaft and capable of rotating together with the rotor shaft;
a plurality of stages of stator blades that are fixed to the casing and arranged between the plurality of stages of rotor blades; and
a plurality of stages of stator blade spacers that support the plurality of stages of stator blades, wherein
the vacuum pump includes
a temperature controlling means that is provided in a specific spacer constituting one of the plurality of stages of stator blade spacers and controls a temperature of the specific spacer, and
a temperature sensor that is provided at a position closer to the temperature controlling means than a gas flow path of a turbo pump portion constituted by the plurality of stages of rotor blades and the plurality of stages of stator blades.

2. The vacuum pump according to claim 1, wherein
the casing includes an outer cylinder that is arranged on an outer peripheral side of the rotor shaft and a base portion that is arranged below the outer cylinder, and
the specific spacer is made of a member having higher heat conductivity than the outer cylinder.

3. The vacuum pump according to claim 2, wherein
the specific spacer is made of an aluminum material.

4. The vacuum pump according to claim 1, wherein
the specific spacer is arranged between a stator blade of an uppermost stage and a stator blade of a lowermost stage among the plurality of stages of stator blades.

5. The vacuum pump according to claim 4, wherein
the specific spacer covers an outer peripheral side of a stator blade spacer adjacent in an axial direction.

6. The vacuum pump according to claim 5, wherein
the specific spacer includes a supporting portion that supports the stator blade spacer adjacent in the axial direction and an overhanging portion that overhangs from the supporting portion to an outside in a radial direction and covers the outer peripheral side of the stator blade spacer, and
thickness of the overhanging portion is greater than thickness of the supporting portion.

7. The vacuum pump according to claim 1, wherein
the temperature sensor is provided at a position between the gas flow path and the temperature controlling means in a radial direction.

8. The vacuum pump according to any one of claims 1 to 7, further comprising:
a stator component that is arranged on a downstream side of the plurality of stages of rotor blades and the plurality of stages of stator blades and constitutes a part of a thread groove pump portion, wherein
the stator component is heated by a heating means.
